# EUROPEAN PATENT SPECIFICATION

(11) **EP 1 841 687 B1**
(45) Date of publication and mention of the grant of the patent: **21.05.2008**
(21) Application number: 06701791.3
(22) Date of filing: 10.01.2006
(51) Int. Cl.: B81B 3/00, G02B 26/08

(54) **MICRO ELECTROMECHANICAL DEVICE FOR TILTING A BODY IN TWO DEGREES OF FREEDOM**
ELEKTROMECHANISCHE MIKROVORRICHTUNG ZUM KIPPEN EINES KÖRPERS UM ZWEI FREIHEITSGRADE
DISPOSITIF MICROELECTROMECANIQUE CONÇU POUR INCLINER UN CORPS SELON DEUX DEGRES DE LIBERTE

(30) Priority: 17.01.2005 EP 05100229
(43) Date of publication of application: 10.10.2007
(73) Proprietor: Koninklijke Philips Electronics N.V., 5621 BA Eindhoven (NL)
(72) Inventor: MEUWESE, Mark, T., NL-5656 AA Eindhoven (NL); VAN LIEROP, Diederik, NL-5656 AA Eindhoven (NL); ASJES, Ronald, J., NL-5656 AA Eindhoven (NL); JANSEN, Gerardus, L., M., NL-5656 AA Eindhoven (NL); VAN GRUNSVEN, Eric, C., E., NL-5656 AA Eindhoven (NL); BROUWER, Dannis, M., NL-5656 AA Eindhoven (NL)
(74) Representative: Schouten, Marcus Maria
(86) International application number: PCT/IB2006/050089
(87) International publication number: WO 2006/075292

(56) References cited:
- US-A1- 2003 123 126
- US-B1- 6 433 917
- HORENSTEIN M N ET AL: "Electrostatic Effects in Micromachined Actuators for Adaptive Optics" JOURNAL OF ELECTROSTATICS, ELSEVIER SCIENCE PUBLISHERS B.V. AMSTERDAM, NL, vol. 42, no. 1-2, October 1997 (1997-10), pages 69-81, XP004096569 ISSN: 0304-3886

## Description

The present invention relates to a micro electromechanical device for tilting a body in two degrees of freedom and an optical scanning device comprising the micro electromechanical device for tilting a body.

Optical devices such as scanning devices, optical couplers for optical networks, projection displays or the like, often require devices for actuating or tilting bodies respectively optical elements in particular deflection mirrors, e.g. as micro electromechanical systems (MEMS) for reflectively deflecting a light beam.

Basically two types of tilting deflection mirror devices exist, namely the resonant type and the open loop controlled type.

The resonant type deflection mirror devices are used in scanning appliances such as displays or the like. The mirror in its suspension acts as a mass on a spring, resulting in a mechanical natural frequency. The damping coefficient is usually low as these mirrors are elastically suspended. These systems are ideal for operation at the resonant frequency, providing large deflection amplitudes at low actuation power input.

In open loop controlled deflection mirror devices the deflection angles are measured externally or are not measured at all, resulting in 2 controlled positions, namely stable or in maximum deflection angle. Such systems neither receive nor act on position information.

Known two-degrees-of freedom deflection mirror devices are built up using two individual suspensions, limiting deflection (angular stiffness too high) and control bandwidth (mass too high). Current suspension solutions are only adequate for one degree of freedom controlled deflection mirrors, or low bandwidth two degrees of freedom deflection mirrors.

An example of a two-degrees-of-freedom miror device is shown in US 2003/123126 A1.

In Trey Roessig et al., "Mirrors with Integrated Position Sense Electronics for Optical-Switching Applications", Analog Dialogue, Volume 36, Number 4, July-August, 2002 a movable micro electromechanical mirror for all-optical switches with position sensing used in a feedback control loop is described.

It is an object of the present invention to provide a micro electromechanical device for tilting a body in two degrees of freedom with a high control bandwidth, providing large deflection angles.

In a first aspect, the present invention provides a micro electromechanical device for tilting a body in two degrees of freedom comprising a carrier element and a membrane, the body being connected via the membrane to the carrier element, wherein the body and the carrier element each comprise at least one electrode and wherein the body is tilted by means of electrostatic forces between the at least one electrode of the body and the at least one electrode of the carrier element by an application of a voltage to the electrodes from a voltage source.

The suspension of the body using a membrane makes an actuation or a tilting of the body in two degrees of freedom possible at low stiffness resulting in large deflection angles at low attenuation power. The separation between the desired two low natural frequencies in the actuation direction and disturbing higher natural frequencies can be made up to a factor 20, which improves the control stability.

In a preferred embodiment, said membrane is a polymer membrane. The polymer membrane is tough, durable and can withstand high strain. The membrane can e.g. be made of polyimide or parylene.

In another embodiment, said membrane comprises different eigenfrequencies for different tilting directions. If it is desired that the tilting body comprises different eigenfrequencies in different tilting directions, a resonant operation mode will be used. The membrane should therefore comprise a non-rotational symmetric shape, such as an elliptical or a rectangular shape.

In a further embodiment, the tilting of the body is controlled by a closed feedback loop with position sensing. This improves the resistance of the device against shock and vibration. For the position sensing a capacitive measurement of the electrodes can be applied.

In a further embodiment, the at least one electrode of the body is connected to the voltage source via at least one lead across the membrane, said at least one lead across the membrane is zigzag-shaped. In this embodiment no wires have to be attached to the moving parts of the body. An electrical lead across the membrane, in particular on its surface will influence the membrane properties significantly, which can decrease the deflection angle of the tilting micro electromechanical device. Using a thin (250 nm) an narrow (5 micron) lead still influence the membranes compliance because the Young's modulus of the polymer membrane is roughly two orders lower than the Young's modulus of copper. The high compliance polymer membrane with low stiffness is easily influenced by a relatively high stiffness electrical lead on the membrane. By using a zigzag-shaped lead, the strain in the lead is reduced which is important, because the strain mainly accounts for the unwanted stiffness increase of the membrane.

In a preferred embodiment, the tilted body is a optical element in particular a deflection mirror.

In another aspect, the present invention provides an optical scanning device comprising a light source, a deflection mirror and the micro electromechanical device for tilting the deflection mirror, said deflection mirror reflectively deflecting a light beam projected from the light source to scan a surface.

Besides optical scanning devices, the device for tilting a body can also be used in devices such as inkjet heads, laser deflectors, optical couplers for optical networks, beamers, barcode readers, projection displays, adaptive optics, identification systems or the like as well as for astronomical imaging, tracking, vision or maskless lithography.

These and other aspects of the invention are apparent from and will be elucidated by way of example with reference to the embodiment described hereinafter and illustrated in the accompanying drawings.

In the drawings:
Fig. 1 shows a schematic side view of a micro electromechanical device for tilting a deflection mirror;
Fig. 2 shows a schematic side view of a micro electromechanical device for tilting a deflection mirror in a second embodiment;
Fig. 3 shows a schematic side view of an optical scanning device comprising the micro electromechanical device for tilting a deflection mirror according to Fig. 1;
Fig. 4 shows a perspective view of another embodiment of a micro electromechanical device for tilting a deflection mirror;
Fig. 5 shows an enlarged cut out of the device according to Fig. 4; and
Fig. 6 shows a further enlarged cut out of the device according to Fig. 4.

In the following the invention is described with an optical element in particular a deflection mirror as tilting body. In further embodiments other bodies or optical elements could also be used.

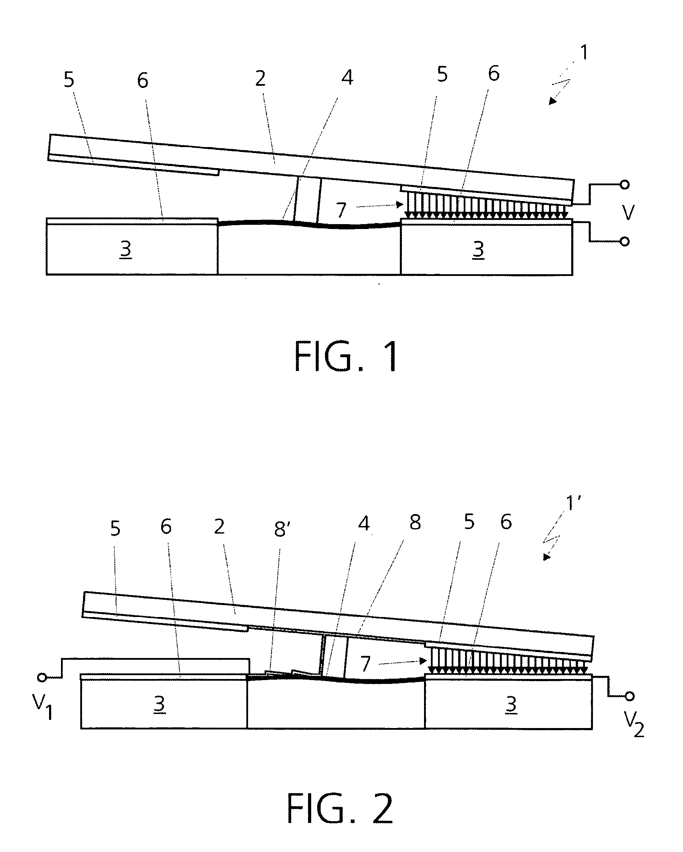

As can be seen from Fig. 1, a micro electromechanical device 1 for tilting a body in particular a deflection mirror 2 in two degrees of freedom comprises a carrier element 3 with which the deflection mirror 2 is connected via a polymer membrane 4. The deflection mirror 2 and the carrier element 3 each comprise electrodes 5, 6, wherein the deflection mirror 2 is tilted with electrostatic forces (electrical field shown as arrows 7) between the electrodes 5 of the deflection mirror 2 and the electrodes 6 of the carrier element 3, by an application of a voltage to the electrodes 5, 6 from a voltage source V. The suspension of the deflection mirror 2 using the polymer membrane, e.g. made of polyimide or parylene makes an actuation or a tilting of the deflection mirror 2 in two degrees of freedom possible at low stiffness resulting in large deflection angles at low attenuation power.

The tilting of the deflection mirror 2 is controlled by a closed feedback loop with position sensing. This improves the resistance of the micro electromechanical device 1 against shock and vibration. For the position sensing a capacitive measurement of the electrodes 5, 6 is applied (not shown). Such a position sensing is e.g. known from Trey Roessig et al., "Mirrors with Integrated Position Sense Electronics for Optical-Switching Applications", Analog Dialogue, Volume 36, Number 4, July-August, 2002.

In another embodiment (not shown), the polymer membrane 4 could comprise different eigenfrequencies for different tilting directions. If it is desired that the tilting body 2 has different eigenfrequencies in the different tilting directions, a resonant operation mode will be used. In this case the polymer membrane 4 should comprise an elliptical or a rectangular shape or another non-rotational symmetric shape.

Fig. 2 shows a schematic side view of a micro electromechanical device 1' for tilting the deflection mirror 2. The electrodes 5 of the deflection mirror 2 are connected to a voltage V₁ via a lead 8, whereas the electrodes 6 of the carrier element 3 are connected to a voltage V₂ of a voltage source. In this embodiment no wires have to be attached to the moving parts of the deflection mirror 2. The part 8' of the lead 8 which leads across the polymer membrane 4 is zigzag-shaped. An electrical lead 8' on the surface of the polymer membrane 4 will influence the polymer membrane 4 properties significantly, which can decrease the deflection angle of the tilting device 1'. The high compliance polymer membrane 4 with low stiffness is easily influenced by a relatively high stiffness electrical lead 8' on the polymer membrane 4. By using a zigzag-shaped lead 8', the tensile stress in the lead 8' is relieved which is important, because the tensile stress mainly accounts for the unwanted stiffness increase of the polymer membrane 4.

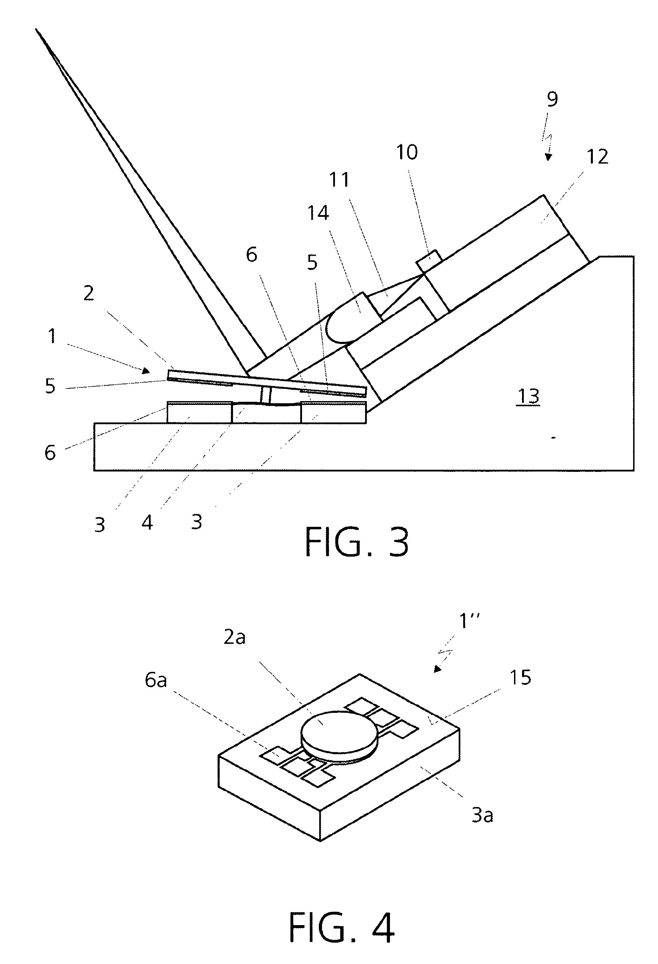

Fig. 3 shows an optical scanning device 9 comprising a light source in particular a laser 10, emitting a light beam 11. The laser 10 is arranged on a heatsink 12 which is mounted on a base 13. The optical scanning device 9 further comprises the deflection mirror 2 and the micro electromechanical device 1 for tilting the deflection mirror 2, said deflection mirror 2 reflectively deflecting the light beam 11 projected from a Perspex lens 14 to scan a surface (not shown).

In further embodiments (not shown), the device for tilting a body can also be used in devices such as inkjet heads, laser deflectors, optical couplers for optical networks, beamers, barcode readers, projection displays, adaptive optics, identification systems or the like as well as for astronomical imaging, tracking, vision or maskless lithography.

The invention is not limited to micro electromechanical system (MEMS) devices. In other embodiments the device according to the invention could also be used as a larger (conventional) device.

Fig. 4 shows a perspective view of another embodiment 1" of a micro electromechanical device for tilting a deflection mirror 2a, on a carrier element 3a comprising a thin polymer layer 15 and electrodes 6a on its surface.

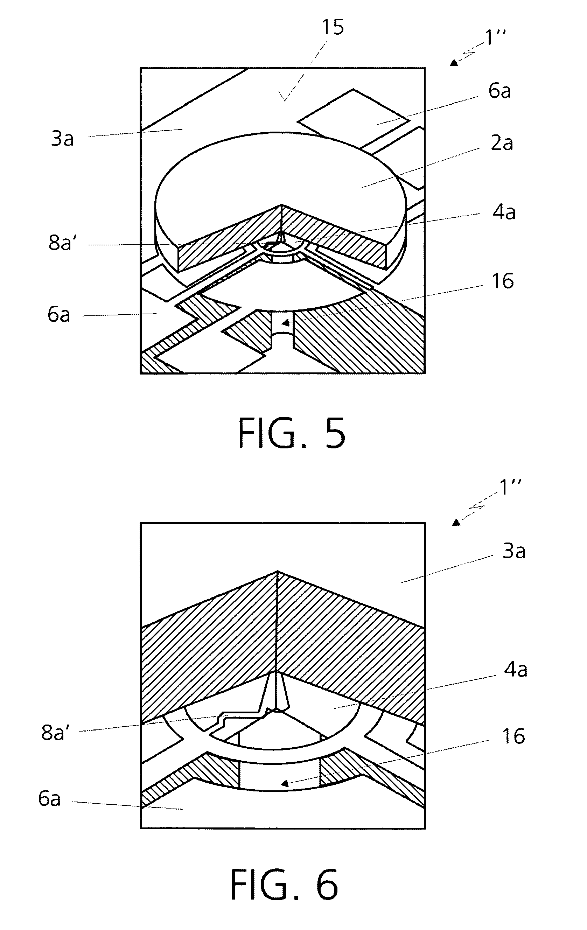

Fig. 5 shows an enlarged cut out of the device 1". The carrier element 3a comprises a cut out revealing a hole 16. Furthermore the polymer membrane 4a with the zigzag-shaped lead 8a' can be seen. Fig. 6 shows a further enlarged cut out of the device 1 ".

## Claims

1. A micro electromechanical device (1,1',1") for tilting a body (2,2a) in two degrees of freedom comprising a carrier element (3,3a) and a membrane (4,4a), the body (2,2a) being connected via the membrane (4,4a) to the carrier element (3,3a), wherein the body (2,2a) and the carrier element (3,3a) each comprise at least one electrode (5,6,6a) and wherein the body (2,2a) is tilted by means of electrostatic forces (7) between the at least one electrode (5) of the body (2,2a) and the at least one electrode (6,6a) of the carrier element (3,3a) by an application of a voltage to the electrodes (5,6,6a) from a voltage source (V).

2. The micro electromechanical device as claimed in claim 1, wherein said membrane is a polymer membrane (4,4a).

3. The micro electromechanical device as claimed in claim 1 or 2, wherein said membrane (4,4a) comprises different eigenfrequencies for different tilting directions.

4. The micro electromechanical device as claimed in claim 1, 2 or 3, wherein said membrane (4,4a) comprises a non-rotational symmetric shape.

5. The micro electromechanical device as claimed in any of claims 1 to 4, wherein said membrane (4,4a) comprises an elliptical shape.

6. The micro electromechanical device as claimed in any of claims 1 to 4, wherein said membrane (4,4a) comprises a rectangular shape.

7. The micro electromechanical device as claimed any of claims 1 to 6, wherein the tilting of the body (2,2a) is controlled by a closed feedback loop with position sensing.

8. The micro electromechanical device as claimed in any of claims 1 to 7, wherein the at least one electrode (5) of the body (2,2a) is connected to the voltage source via at least one lead (8',8a') across the membrane (4,4a).

9. The micro electromechanical device as claimed in claim 8, wherein the at least one lead (8',8a') across the membrane (4,4a) is zigzag-shaped.

10. The micro electromechanical device as claimed in any of claims 1 to 9, wherein the body is an optical element (2,2a).

11. The micro electromechanical device as claimed in claim 10, wherein the optical element is a deflection mirror (2,2a).

12. An optical scanning device (9) comprising a light source (10), a deflection mirror (2) and a micro electromechanical device (1) for tilting the deflection mirror (2) according to claim 11, said deflection mirror (2) reflectively deflecting a light beam (11) projected from the light source (10) to scan a surface.

## Patentansprüche

1. Elektromechanische Mikrovorrichtung (1,1',1") zum Kippen eines Körpers (2,2a) um zwei Freiheitsgrade, welche ein Trägerelement (3,3a) und eine Membran (4,4a) umfasst, wobei der Körper (2,2a) über die Membran (4,4a) mit dem Trägerelement (3,3a) verbunden ist, wobei der Körper (2,2a) und das Trägerelement (3,3a) jeweils mindestens eine Elektrode (5,6,6a) aufweisen und wobei der Körper (2,2a) mit Hilfe von elektrostatischen Kräften (7) zwischen der mindestens einen Elektrode (5) des Körpers (2,2a) und der mindestens einen Elektrode (6,6a) des Trägerelements (3,3a) durch Anlegen einer Spannung aus einer Spannungsquelle (V) an die Elektroden (5,5,6a) gekippt wird.

2. Elektromechanische Mikrovorrichtung nach Anspruch 1, wobei die Membran eine Polymermembran (4,4a) ist.

3. Elektromechanische Mikrovorrichtung nach Anspruch 1 oder 2, wobei die Membran (4,4a) verschiedene Eigenfrequenzen für verschiedene Kipprichtungen aufweist.

4. Elektromechanische Mikrovorrichtung nach Anspruch 1,2 oder 3, wobei die Membran (4,4a) eine nicht rotierende, symmetrische Form aufweist.

5. Elektromechanische Mikrovorrichtung nach einem der Ansprüche 1 bis 4, wobei die Membran (4,4a) eine elliptische Form aufweist.

6. Elektromechanische Mikrovorrichtung nach einem der Ansprüche 1 bis 4, wobei die Membran (4,4a) eine rechteckige Form aufweist.

7. Elektromechanische Mikrovorrichtung nach einem der Ansprüche 1 bis 6, wobei das Kippen des Körpers (2,2a) durch eine geschlossene Rückkopplungsschleife mit Positionsbestimmung gesteuert wird.

8. Elektromechanische Mikrovorrichtung nach einem der Ansprüche 1 bis 7, wobei die mindestens eine Elektrode (5) des Körpers (2,2a) mit der Spannungsquelle über mindestens eine Zuleitung (8',8a') über die Membran (4,4a) verbunden ist.

9. Elektromechanische Mikrovorrichtung nach Anspruch 8, wobei die mindestens eine Zuleitung (8',8a') über die Membran (4,4a) zickzackförmig ist.

10. Elektromechanische Mikrovorrichtung nach einem der Ansprüche 1 bis 9, wobei der Körper ein optisches Element (2,2a) ist.

11. Elektromechanische Mikrovorrichtung nach Anspruch 10, wobei das optische Element ein Ablenkspiegel (2,2a) ist.

12. Optische Abtastvorrichtung (9) mit einer Lichtquelle (10), einem Ablenkspiegel (2) und einer elektromechanischen Mikrovorrichtung (1) zum Kippen des Ablenkspiegels (2) nach Anspruch 11, wobei der Ablenkspiegel (2) einen Lichtstrahl (11) reflektierend ablenkt, der von der Lichtquelle (10) zum Abtasten einer Oberfläche projiziert wird.

## Revendications

1. Dispositif microélectromécanique (1, 1', 1") pour incliner un corps (2, 2a) selon deux degrés de liberté, comprenant un élément porteur (3, 3a) et une membrane (4, 4a), le corps (2, 2a) étant raccordé via la membrane (4, 4a) à l'élément porteur (3, 3a), dans lequel le corps (2, 2a) et l'élément porteur (3, 3a) comprennent chacun au moins une électrode (5, 6, 6a) et dans lequel le corps (2, 2a) est incliné au moyen de forces électrostatiques (7) entre la au moins une électrode (5) du corps (2, 2a) et la au moins une électrode (6, 6a) de l'élément porteur (3, 3a) par application d'une tension aux électrodes (5, 6, 6a) à partir d'une source de tension (V).

2. Dispositif microélectromécanique selon la revendication 1, dans lequel ladite membrane est une membrane polymère (4, 4a).

3. Dispositif microélectromécanique selon la revendication 1 ou 2, dans lequel ladite membrane (4, 4a) comprend différentes fréquences propres pour différentes directions d'inclinaison.

4. Dispositif microélectromécanique selon la revendication 1, 2 ou 3, dans lequel ladite membrane (4, 4a) comprend une forme sans symétrie de révolution.

5. Dispositif microélectromécanique selon l'une quelconque des revendications 1 à 4, dans lequel ladite membrane (4, 4a) comprend une forme elliptique.

6. Dispositif microélectromécanique selon l'une quelconque des revendications 1 à 4, dans lequel ladite membrane (4, 4a) comprend une forme rectangulaire.

7. Dispositif microélectromécanique selon l'une quelconque des revendications 1 à 6, dans lequel l'inclinaison du corps (2, 2a) est commandée par une boucle de rétroaction fermée avec détection de position.

8. Dispositif microélectromécanique selon l'une quelconque des revendications 1 à 7, dans lequel la au moins une électrode (5) du corps (2, 2a) est connectée à la source de tension via au moins un conducteur (8', 8a') à travers la membrane (4, 4a).

9. Dispositif microélectromécanique selon la revendication 8, dans lequel le au moins un conducteur (8', 8a') à travers la membrane (4, 4a) est conformé en zigzag.

10. Dispositif microélectromécanique selon l'une quelconque des revendications 1 à 9, dans lequel le corps est un élément optique (2, 2a).

11. Dispositif microélectromécanique selon la revendication 10, dans lequel l'élément optique est un miroir de déflexion (2, 2a).

12. Dispositif de balayage optique (9), comprenant une source de lumière (10), un miroir de déflexion (2) et un dispositif microélectromécanique (1) pour incliner le miroir de déflexion (2) selon la revendication 11, ledit miroir de déflexion (2) déviant par réflexion un faisceau lumineux (11) projeté par la source de lumière (10) pour balayer une surface.
